(19) Europäisches Patentamt / European Patent Office / Office européen des brevets

(11) **EP 2 242 188 A1**

(12) **EUROPEAN PATENT APPLICATION**
published in accordance with Art. 153(4) EPC

(43) Date of publication:
**20.10.2010 Bulletin 2010/42**

(51) Int Cl.:
*H04B 7/04* (2006.01)  *H04B 7/14* (2006.01)
*H03M 13/37* (2006.01)  *H04W 88/02* (2009.01)

(21) Application number: **09710559.7**

(22) Date of filing: **04.02.2009**

(86) International application number:
**PCT/CN2009/000128**

(87) International publication number:
**WO 2009/100650 (20.08.2009 Gazette 2009/34)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **04.02.2008  CN 200810033556**

(71) Applicant: **Alcatel Lucent**
**75008 Paris (FR)**

(72) Inventors:
• **WANG, Yonggang**
  **Shanghai 201206 (CN)**
• **CHEN, Yu**
  **Shanghai 201206 (CN)**

(74) Representative: **Dreiss, Uwe**
  **Dreiss Patentanwälte**
  **Postfach 10 37 62**
  **70032 Stuttgart (DE)**

(54) **RELAYING METHOD, BASE STATION AND USER EQUIPMENT FOR JOINT ANALOG NETWORK CODING**

(57)    The present invention provides a joint analog network coding and relay method, a reception method, a base station, and a user equipment for use in a cellular network with a wireless relay. Said relay method comprises steps of: receiving information signals from a plurality of base stations eNB; sampling and ADC the received signals; analog network coding the analog signal levels carrying the information signals from the plurality of eNBs; forwarding symbols after being analog network coded; and receiving the forwarded symbols and converting the symbols into the information signals. Wireless relay joint with analog network coding is a low-cost, low-complexity solution which could im prove the service transmission performance when UE is at the cell edge, and increase the cell coverage.

**Fig. 2**

**Description**

**FIELD OF THE INVENTION**

The present invention relates to the wireless cellular network communication, especially to high-rate, wideband wireless communication, e.g. 3GPP LTE based OFDM, and in particularly relates to a joint analog network coding and relay method, receiving and transmitting method and apparatus thereof.

**BACKGROUND OF THE INVENTION**

In a broad sense, a network coding is a multicast technique in which a node in the network encodes the received information and then forwards it out. The multicast is an important communication form in the network. When one or more nodes simultaneously send data to some other nodes, it often seeks help for the transfer by other nodes. In a conventional network, the node acting as a relay may only copy, amplify and forward the received signal, which is wasteful for the network resource sometimes. The network coding technique breaks such a limitation, allows the relay node to encode the received information, and recombines a plurality of received data packets in term of a specific algorithm and transmits them out. The network coding technique may significantly improve the data rate for the multicast. The information transmitted in a network may be called as a "stream" vividly. The maximum flow of the network is the maximum data transmission rate from a source node to a receiving node. The maximum flow for the broadcast is the maximum data transmission rate received by each of receiving nodes when a source node simultaneously transmits the same data to all of the receiving nodes. Theoretically, the maximum flow lies on the network topology structure, i.e. the connection relationship of the respective nodes and the bandwidth. The max-flow min-cut theorem which is famous in the graph theory may be employed to obtain the max flow from some source node to some receiving node in a given network. The network coding actually gets higher network efficiency in return for the node processing ability.

In cellular wireless communication network, the base station has the fixed site and maximum transport power. So the coverage is invariable, and to improve the performance of UE at cell edge, some wireless communication techniques are implemented, for example, soft handover in CDMA systems. However, in general mobile communication systems such as UMTS Rel5 HSDPA and LTE, the macro diversity and soft combining of power contribution come from adjacent base station is not employed in order to achieve the independent, more fast and more flexible AMC, MAC scheduling and L1 HARQ. Therefore, a higher peak data transmission rate could be achieved when UE is near the site. But when UE is far from the site, e.g. at the cell edge, no so good technique could improve the service transmission performance so as to increase the spectrum efficiency.

A wireless relay concept has been introduced in WiMax, but it has not been discussed in cellular networks. Since the present invention relates to a new application in the cellular network communication, there is no such a technical solution in the prior art.

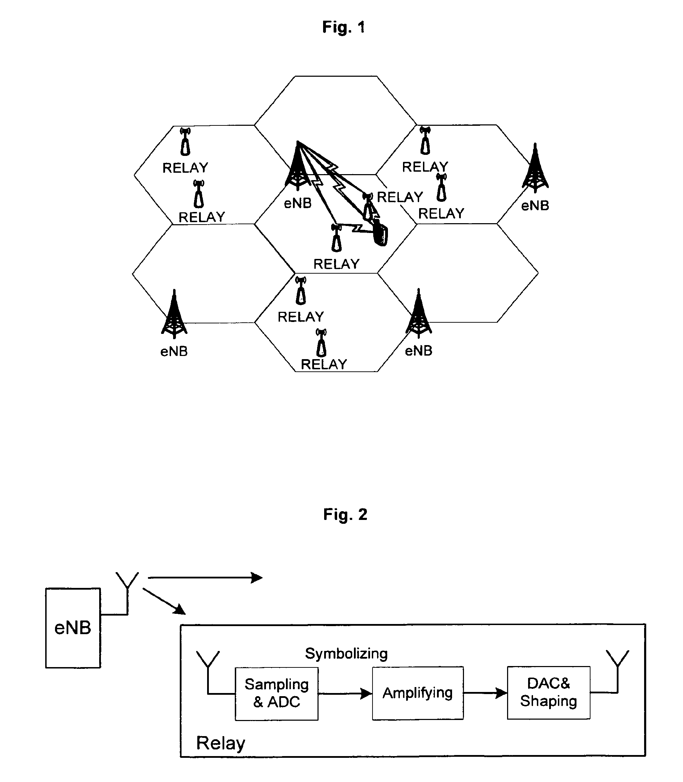

Fig. 1 illustrates the deployment of a cellular network with a wireless relay station. As an example, the relay station is located at the 1/3 distance to the cell edge. The relay may have the baseband processing function and can forward data coming from eNB. The relay transports the data at the same frequency as used by the eNB but time division multiplexing with the source.

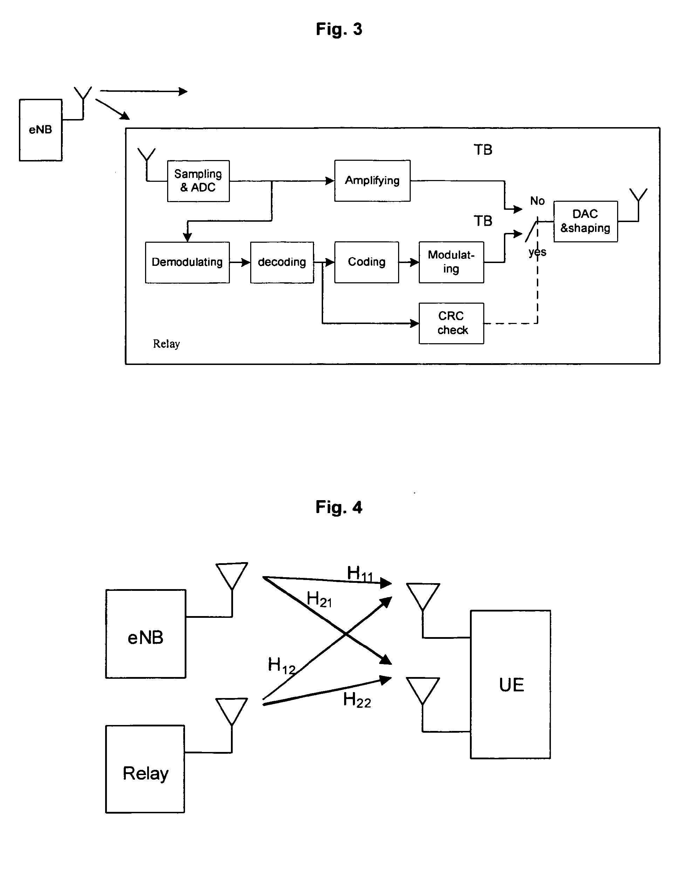

The relay may play several roles, among which, one is to amplify and forward the data, another is to decode and forward the data. In particularly, the scheduling of data receiving and transmitting in the relay is shown in Fig. 2 and Fig. 3. Fig. 2 shows the structure of relay in amplifying and forwarding used in a communication apparatus with a radio relay. As shown in Fig. 2, the relay station receives analog data form eNB via an antenna and the data is sampled and analog-to-digital converted (ADC); the ADC digital signal is symbolized; the symbolized digital level is amplified; and finally, the amplified digital level is digital-to-analog converted and shaped, and the shaped analog signal is forwarded via an antenna. Fig. 3 shows the structure of relay in coding and forwarding used in a communication apparatus with a radio relay. As shown in Fig. 3, the relay eceives analog data from eNB via an antenna and the data is sampled and analog-to-digital converted; the ADC digital signal is divided into two ways, one of which is subject to the actions shown in Fig. 2 to amplify the symbolized digital level, and the other of which is subject to demodulation, and decoding, and, after decoding, to a cycle redundancy check (CRC) and at the same time to encoding and modulating; if it passes the CRC check, the signal in the way of demodulating, decoding, encoding and modulating is DAC and shaped; or otherwise, if it does not pass the CRC check, the signal which is only amplified after the sampling and ADC is DAC and shaped; and finally the shaped analog signal is forwarded via an antenna.

**SUMMARY OF THE INVENTION**

The objective of the present invention is to propose a cellular network deployment by employing a joint analog network coding and a radio relay, i.e. network coding of a physical signal carrying information form a plurality of sources.

It further discloses a transmission/reception scheme and the design for the transmitter/receiver.

In accordance with a first aspect of embodiment of the present invention, there is provided a joint analog network coding and relay method for use in a cellular network with a wireless relay, which comprises steps of: receiving information signals from a plurality of base stations eNBs; sampling and Analog-to-digital converting the received signals; analog network coding the analog signal levels carrying the information from the plurality of eNBs; forwarding symbols after being analog network coded; and receiving the forwarded symbols and converting the symbols into the information signals.

Preferably, said base station comprises a preceding relay station for forwarding data, and analog network coding is performed on the signals from said base station eNB and said preceding relay station.

Preferably, said relay station time alternates alternately and carries the analog network coded information signals.

Preferably, wherein said analog network coding comprises a physical signal summation.

Preferably, said physical signal summation comprises a step of performing a weighting summation on signal blocks divided from the time slots.

In accordance with a second aspect of the present invention, there is provided a reception method with a joint analog network coding and relay for use in a cellular network with a wireless relay, which comprises steps of: performing collaborative Multiple Input and Multiple Output operation on signals received from a plurality of eNBs or Relays; and a User Equipment decoding the signals received through said MIMO operation by joint detection technique.

Preferably, said joint detection technique comprises a MIMO spatial de-multiplexing.

Preferably, said joint detection technique comprises a successive interference cancellation SIC.

Preferably, said decoding step is based on a Maximum-Likelihood ML method.

Preferably, said decoding step is based on a Minimum Mean-Square Error algorithm together with Zero Forcing algorithm.

Preferably, the Chase combining or IR combining is adopted for decoding after the UE receives the signals.

In accordance with a third aspect of the present invention, there is provided a base station, which comprises: a sampling and ADC unit, for sampling and Analog-to-Digital converting the signals to be sent; a coding unit, for analog network coding the analog signal levels carrying information from a plurality of eNBs; a sending unit, for forwarding analog network coded symbols.

Preferably, said coding unit implements the analog signal coding by employing a physical signal summation.

Preferably, said coding unit implements the analog signal coding by employing a weighting summation on signal blocks divided from time slots.

In accordance with a fourth aspect of the present invention, there is provided a user equipment, which comprises: a receiving unit, for receiving information from a base station; a decoding unit, for carrying out decoding by a joint detection technique; and a sending unit, for forwarding decoded signals.

Preferably, said joint detection technique comprises a MIMO spatial de-multiplexing.

Preferably, said joint detection technique comprises a successive interference cancellation SIC.

Preferably, said decoding unit performs said decoding step based on a Maximum-Likelihood ML method.

Preferably, said decoding unit performs said decoding step based on a Minimum Mean-Square Error algorithm together with Zero Forcing algorithm.

Preferably, the Chase combining or IR combining is adopted by said decoding unit to carry out decoding after the UE receives the signals.

In accordance with a fifth aspect of the present invention, there is provided a computer readable media having a computer executable program recorded thereon, where the program, when mounted on a computer, makes the computer execute the method according to the embodiments of the present invention .

The beneficial effect of the present invention is that: the Relay in accordance with the embodiment of the present invention does the analog network coding, i.e. the physical signals carrying information of current slot/block analog network coded with previous ones are used to transmit the service data. In amplifying and forwarding data, UE receives the signal from eNB and relays it, and detects the slot by collaborative MIMO de-spatial MUX or successive interference cancellation; each time UE only reserves one slot hard decision, others' prior soft information are used for the next slot detection, which improves the UE receiving performance. In decoding and forwarding data, UE buffers the soft information of one block which is received from eNB, and then adopts the Chase combining or IR combining after receiving the data from relay to obtain the diversity gain. From the analysis in theory of the form of Channel Matrix united by eNB and Relay, It is found that the unite detection in receiver can provide at least the similar performance as traditional 2*2 transmit diversity. Additionally, the analog network coding in relay of two symbols obtains the similar performance of 3*3 MIMO. Even due to the larger SNR received from relay, the gain would be much more. The advantage of the present invention over the optimal prior art is that the joint analog network coding and wireless relay is a new application in wireless communication. Because in current HSDPA and LTE, AMC, MAC scheduling and L1 HARQ techniques all focus on the high peak rate of data transmission rate when UE is near the site, wireless relay join with analog network coding is a low-cost, low-complexity solution which could improve the service transmission performance when UE is at the cell edge, and increase the cell coverage.

## BRIEF DESCRIPTION OF THE DRAWINGS

The advantages of the present invention will be apparent from the following detailed description taken in conjunction with the drawings, in which:

Fig. 1 shows the deployment of cellular network with wireless relay;
Fig. 2 shows the structure of relay in amplifying and forwarding used in a communication apparatus with a radio relay;
Fig. 3 shows the structure of relay in coding and forwarding used in a communication apparatus with a radio relay;
Fig. 4 shows the channel response vectors in the 2x2 Collaborative MIMO scheme;
Fig. 5 shows the channel response vectors in the 2x1 Macro diversity scheme;
Fig. 6 shows the flow chart of the analog network coding method in accordance with the embodiment of the present invention;
Fig. 7 shows the physical processing structure of UE receiver, in which L1 structure of MIMO De-spatial MUX is employed;
Fig. 8 shows the physical processing structure of UE receiver, in which L1 structure of SIC is employed;
Figs. 9a and 9b show data transmission in amplifying and forwarding by employing analog network coding;
Figs. 10a and 10b show data transmission in decoding and forwarding by employing analog network coding;
Fig. 11 shows a schematic view of the communication apparatus with a radio relay in data amplifying and forwarding with analog network coding;
Fig. 12 shows a schematic view of the communication apparatus with a radio relay in data coding and forwarding with analog network coding;
Fig. 13 shows a relay receiver and transmitter system with two half-duplex relays;
Fig. 14 shows a schematic view of data transmission in decoding and forwarding by employing analog network coding in a one slot relay; and
Fig. 15 shows a schematic view of data transmission in decoding and forwarding by employing analog network coding in a two slot relay.

## DETAILED DESCRIPTION OF PREFERRED EMBODIMENTS

Now, detailed descriptions will be provided to embodiments of the present invention. The embodiments of the present invention will be described by referring to the drawings.

The present invention provides a joint analog network coding and radio relay deployment. Two relays alternatively perform the time division to transmit a flow from a source together with analog network coding information, i.e. the physical signals carrying information of current slot/block analog network coded with previous ones. In a terminal receiver, a successive interference cancellation (SIC) and detection of the previous information from the base station may be applied. If there is more than one receiving antenna, a collaborative Multiple Input and Multiple Output (MIMO) operation of eNBs and Relays may be applied, in which the current information is used as one branch. From the analysis in theory of the form of Channel Matrix united by eNB and Relay, it is found that unite detection in receiver can provide at least the similar performance as traditional 2*2 transmit diversity. Additionally, the analog network coding in relay of two symbols obtains the similar performance of 3*3 MIMO. Even due to the larger SNR received from relay, the gain actually would be much more.

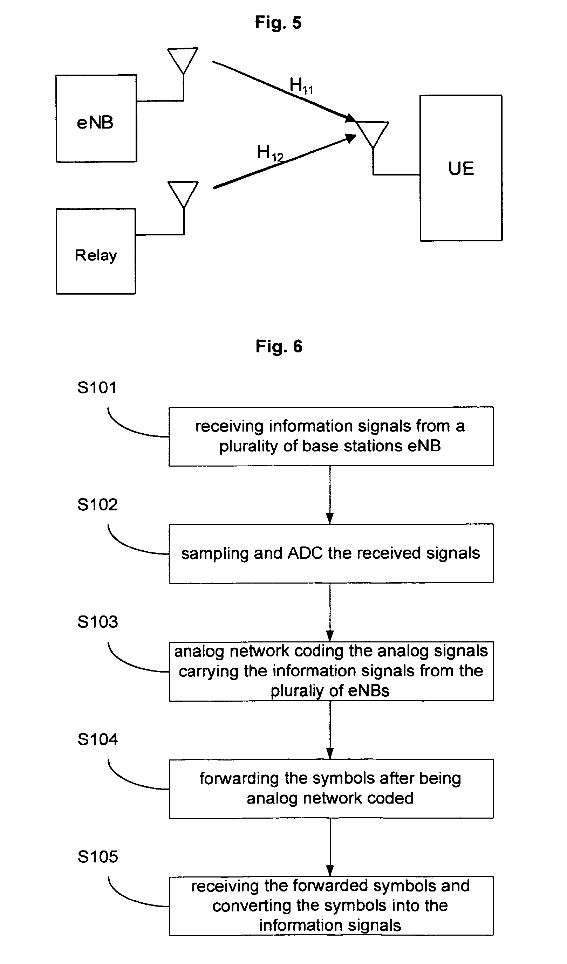

The analog network coding method is applied to the analog signal in the system with relay, in which the analog signal carries information from a plurality of sources. The User Equipment may apply a joint detection technique, i.e. collaborative MIMO spatial de-multiplexing on base station and relay. Fig. 4 shows the channel response vectors in the 2x2 Collaborative MIMO scheme. Fig. 5 shows the channel response vectors in the 2x1 Macro diversity scheme.

Fig. 6 shows the flow chart of the analog network coding and relay method in accordance with the embodiment of the present invention. As shown in Fig. 6, the method comprises the following steps of: receiving information signals from a plurality of base stations eNBs; sampling and Analog-to-digital converting (ADC) the received information signals; analog network coding the digitized levels of the analog signals carrying the information signals from the plurality of eNBs; forwarding the symbols after being analog network coded; and receiving the forwarded symbols and converting the symbols into the information signals.

Said analog network coding refers to a summation of physical signals, i.e. signal coding in the level of an analog signal. Said summation of physical signals comprises a step of performing a weighting summation on the signal blocks divided from the time slots. Said base station eNB may also comprise the preceding relay station for forwarding data, and the analog network coding is performed on the signals from said base station eNB and said preceding relay station. Said relay station time alternates alternately and carries the analog network coded information signals.

In accordance with another embodiment of the present invention, a reception method with a joint analog network coding and relay to be used in a cellular network with wireless relay, comprises the following steps of: performing collaborative Multiple Input and Multiple Output operation on the signals received from a plurality of eNBs or Relays; the User Equipment decoding the signals received through said MIMO operation by joint detection technique. Said joint detection technique comprises a MIMO spatial de-multiplexing. Said joint detection technique comprises a successive interference cancellation SIC. Said decoding method may be a Maximum-Likelihood ML or may be a Minimum Mean-Square Error algorithm together with Zero Forcing algorithm. The Chase combining or IR combining is adopted to carry out decoding after the UE receives the signals.

In accordance with still another embodiment of the present invention, a base station comprises a sampling and ADC unit for sampling and Analog-Digital Converting the signals to be sent, a coding unit for analog network coding the analog signals carrying the information from a plurality of eNBs to symbols, a sending unit for forwarding the analog network coded symbols. Said coding unit implements the analog signal coding by employing a summation of physical signals. Said coding unit implements the analog signal coding by employing a weighting summation on the signal blocks divided from the time slots.

In accordance with still another embodiment of the present invention, a user equipment comprises a receiving unit for receiving information from a base station eNB, a decoding unit for decoding the signals by a joint detection technique and a sending unit for forwarding the decoded signals. Said joint detection technique comprises a MIMO spatial de-multiplexing. Said joint detection technique comprises a successive interference cancellation SIC. Said decoding unit may perform the decoding step based on a Maximum-Likelihood ML. Said decoding unit may perform decoding step based on a Minimum Mean-Square Error algorithm together with Zero Forcing algorithm. The Chase combining or IR combining is adopted by said decoding unit to carrying out decoding after the UE receives the signals.

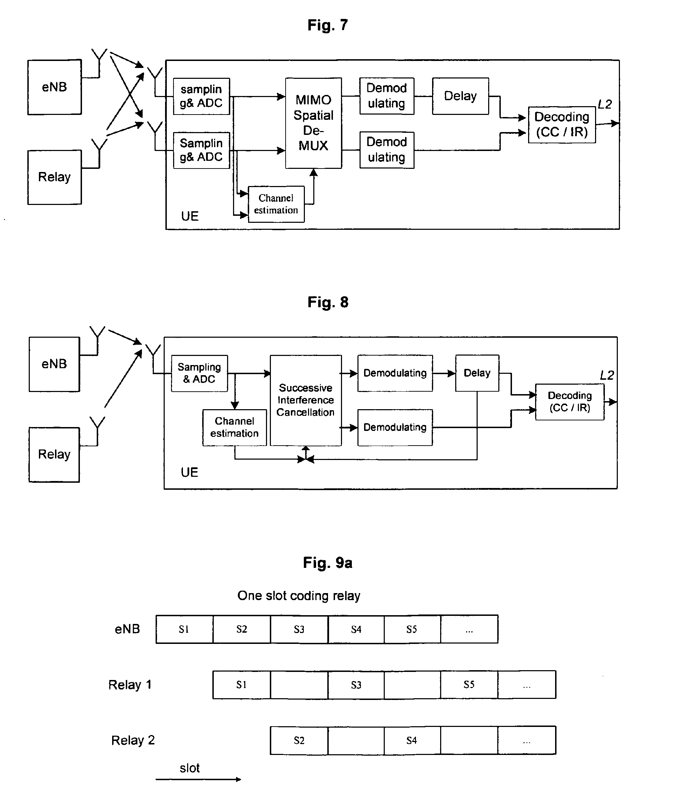

The UE receiver and detection method in decoding and forwarding after channel response vector corresponding to Fig. 4 and Fig. 5 is analog network coded are explained by referencing to Fig. 7and Fig. 8.

Fig. 7 shows the physical processing structure of UE receiver, in which L1 structure of MIMO De-spatial MUX is employed and the user equipment comprises two antennas. As show in Fig. 6, when data is decoded and forwarded, the relay decodes the signal samples and performs cycle redundancy check; and then the data is re-encoded and forwarded to the UE, in which the transmission in the relay is one time slot latter than the transmission in the eNB. The user equipment in the receiving terminal may apply MIMO spatial de-multiplexing to the data signals received from the base station eNB and the relay. The UE buffers the soft information of one block which is received from eNB, and then adopts the Chase combining or IR combining after receiving the data from the relay to obtain the diversity gain.

Fig. 8 shows the physical processing structure of UE receiver, in which L1 structure of SIC is employed and the user equipment UE comprises one antenna. As shown in Fig. 7, the UE in the receiving terminal may apply a successive interference cancellation (SIC) and detection together with the prior information from eNB.

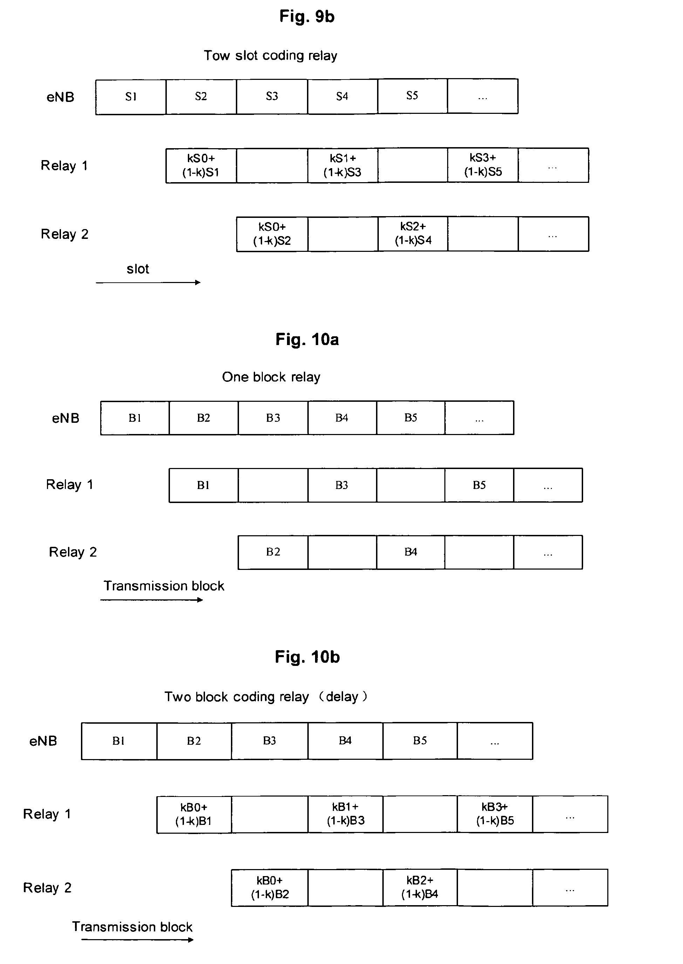

Figs. 9a and 9b show data transmission in amplifying and forwarding by employing analog network coding. As shown in Figs. 9a and 9b, two relays are taken as an example to explain the data relay in amplifying and forwarding data. The relay amplifies the signal sample and forwards it to UE, where the transmission in the relay is one slot delayed than the transmission from eNB. In Fig. 9a, the relay 1 only amplifies and forwards the odd data, the relay 2 only amplifies and forwards the even data, and the delay to the data applied by the relay is one slot. In Fig. 9b, the relay 1 carries out encoding in accordance with $kS_i+(1-k)S_{i+1}$ (i=0, 1, 2...) and the relay 2 carries out encoding in accordance with $kS_i+(1-k)S_{i+1}$ (i=0, 1, 2...), where 0<k<1 is the power factor of the two coding systems, and in Fig. 9b the delay to the data applied by the relay are two slots. It should be appreciated by those skilled in the art that the encoding method is not limited to this, any analog network coding method may be applied to the data amplifying and forwarding in the relay, e.g. the coefficient is defined as k1 and k2 which are complex number, or a network coding with more than two coding symbols may be applied. As shown in Fig. 9b, two slot coding relay could use more than one previous slots' prior information (soft decision information) for detection. Due to the spatial multiplexing between eNB and relay, UE should apply the joint detection technique, where the joint detection method 1 is Collaborative MIMO De-spatial MUX among base station and relay and detection together with the prior information from eNB, and the joint detection method 2 is Successive Interference Cancellation and detection together with the prior information from eNB.

Figs. 10a and 10b show a schematic view of data transmission in decoding and forwarding by employing analog network coding. As shown in Figs. 10a and 10b, two relays are taken as an example to illustrate data relay when amplifying and forwarding data. In decoding and forwarding data, the relay decodes the signal sample and performs CRC check, then re-codes the data and forwards it to UE, where the data block transmitted by the relay is two block delayed than the data block transmitted from eNB.

Also the receiver could apply MIMO De-spatial MUX among base station and relay. UE receiver buffers the soft information of one block, and adopts the Chase combining or IR combining after receiving the data from relay. Furthermore, the receiver could apply Successive Interference Cancellation and detection together the prior information from eNB.

In this invention, the presence of relay node does not impact the operation of eNB, e.g. AMC, MAC scheduling and L1 HARQ. eNB does not care whether the relay node exists, and there is no uplink from relay to eNB, and the control signaling directly transports between eNB and UE. The relay only receives the service data and forwards it to UE. It should be understood that other designs for the control signaling do not affect the implementation of the present invention.

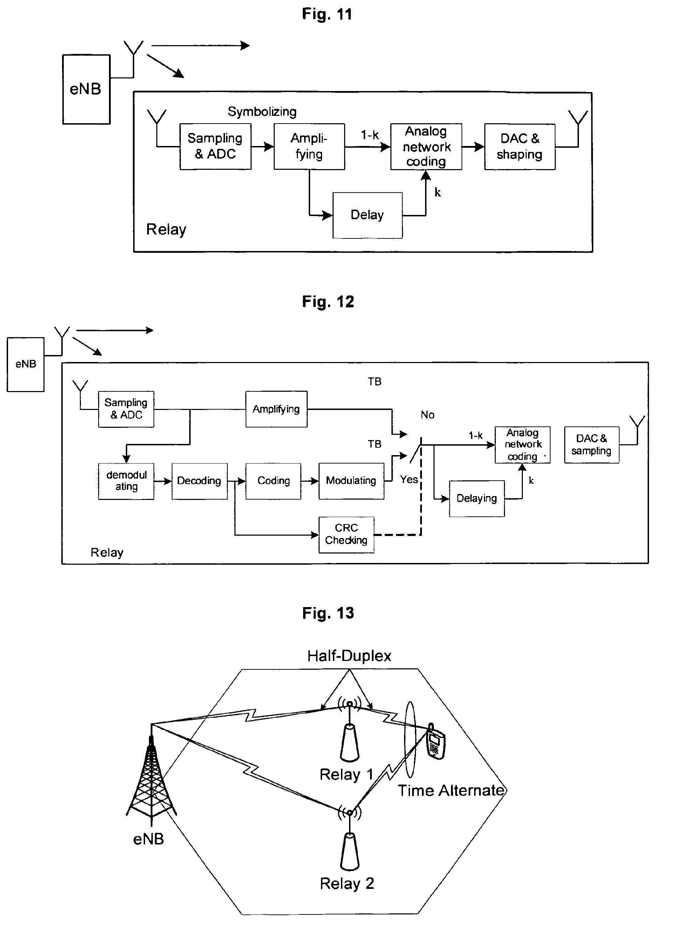

Fig. 11 shows a schematic view of the communication apparatus with a radio relay in data amplifying and forwarding with analog network coding. As shown in Fig. 11, the relay receives analog data from eNB via an antenna and the data is sampled and analog-to-digital converted; the ADC digital signal is symbolized; the symbolized signal is amplified; the amplified signal is analog network coded; and finally, the analog network coded signal is digital-to-analog converted and shaped, and the shaped analog signal is forwarded via an antenna. Therefore, the data amplifying and forwarding in a relay is implemented.

Fig. 12 shows a schematic view of the communication apparatus with a radio relay in data coding and forwarding with analog network coding. As shown in Fig. 12, the relay receives analog data form eNB via an antenna and the data is sampled and analog-to-digital converted; the ADC digital signal is divided to two ways, one of which is amplified, and the other of which is subject to demodulating, and decoding, and after decoding, also to a cycle redundancy check and at the same time to encoding and modulating; if it passes the CRC check, the signal in the way of demodulating, decoding, encoding and modulating is analog network coded; and if it does not pass the CRC check, the signal which is only amplified after the sampling and ADC is analog network coded; then it is digital-to-analog converted and shaped; and finally the shaped analog signal is forwarded via an antenna.

Fig. 13 shows a relay receiver and transmitter system with two half-duplex relays. The system comprises a base station eNB, a half-duplex relay 1and a half-duplex relay 2 and user equipment. As shown in Fig. 13, the two half-duplex relays perform relaying in turn with time slicing to transmit the flow from the source together with the analog network coded information. Each Relay receives and transmits the signal through air interface alternately, and the service data are carried on the time-frequency resource continually by the two relays as shown in Fig. 13. It is appreciated by those skilled in the art that it does not limit to the two relays in the relay receiver and transmitter system shown in Fig. 13. There may be more than two relays, or there may be only one relay.

In the following, the UE receiver and detection method in amplifying and forwarding in according with the embodiment of the present invention is illustrated. When amplifying and forwarding data, the relay amplifies the signal samples and forwards them to the UE, in which the transmission in the relay is one time slot latter than the transmission from the eNB. The UE receiver and detection method is illustrated by taking a UE having two receiving antennas as an example.

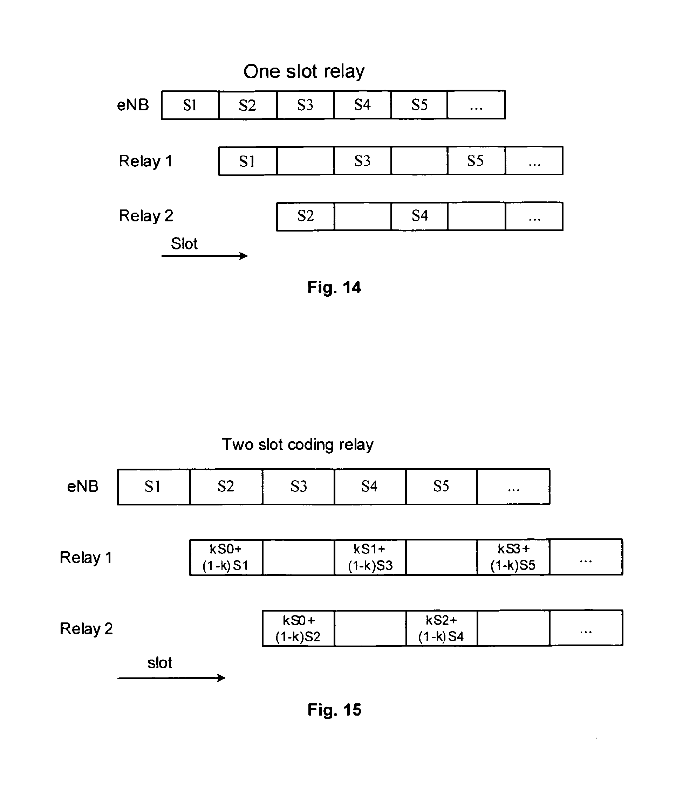

Fig. 14 shows a schematic view of data transmission in decoding and forwarding by employing analog network coding in a one slot relay.

Firstly, UE receives the S1 signal from eNB in the first slot, let

$$y_0 = H_{00}s_1 + n_0 \qquad (1)$$

Secondly, UE receives the S1+S2 signal from eNB and relays it in the second slot, let

$$y_1 = H_{11}s_2 + H_{12}s_1 + n_1$$
$$y_2 = H_{21}s_2 + H_{22}s_1 + n_2 \qquad (2)$$

The above equations may be expressed as the matrix product of

$$\begin{bmatrix} y_0 \\ y_1 \\ y_2 \end{bmatrix} = \begin{bmatrix} H_{00} & 0 \\ H_{12} & H_{11} \\ H_{22} & H_{21} \end{bmatrix} \begin{bmatrix} s_1 \\ s_2 \end{bmatrix} + \begin{bmatrix} n_0 \\ n_1 \\ n_2 \end{bmatrix} \qquad (3)$$

Let

$$y = \begin{bmatrix} y_0 \\ y_1 \\ y_2 \end{bmatrix}, H = \begin{bmatrix} H_{00} & 0 \\ H_{12} & H_{11} \\ H_{22} & H_{21} \end{bmatrix}, s = \begin{bmatrix} s_1 \\ s_2 \end{bmatrix}, n = \begin{bmatrix} n_0 \\ n_1 \\ n_2 \end{bmatrix} \tag{4}$$

The signal vector y formed by the receiver may be expressed as:

$$y = Hs + n \tag{5}$$

The optimum decoding method is ML (Maximum-Likelihood) where the receiver compares all possible combinations of slots which could have been transmitted with what is observed:

$$\hat{s} = \arg \min_{\hat{s} \in S} \left\| y\text{-}H \times \hat{s} \right\| \tag{6}$$

The sub-optimum decoding method is MMSE together with ZF.
But in this slot, only the $s_1$ is subject to hard decision. That is, the hard decision for conversion to digital signal is only performed on $s_1$, the other signals are not subject to decision, and they are united together to perform analog network coding.
At least, let

$$y_0^{(1)} = w_1 \left( y_1 - H_{12}\hat{s}_1 \right) + w_2 \left( y_2 - H_{22}\hat{s}_1 \right) = \left( w_1 H_{11} + w_2 H_{21} \right) s_2 + \tilde{n}_0 \tag{7}$$

which is used for the next slot detection. Here the Maximum Ratio Combination (MRC) is applied as the receiving mechanism used here.
Fig. 15 shows a schematic view of data transmission in decoding and forwarding by employing analog network coding in a two slot relay.
Firstly, UE receives the S1 signal from eNB in the first slot, let

$$y_0 = H_{00}s_1 + n_0 \tag{8}$$

Secondly, UE receives the S1+S2 signal from eNB and relays it in the second slot, let

$$\begin{aligned} y_1 &= H_{11}^{(1)}s_2 + H_{12}^{(1)}s_1 + n_1 \\ y_2 &= H_{21}^{(1)}s_2 + H_{22}^{(1)}s_1 + n_2 \end{aligned} \tag{9}$$

Thirdly, UE receives the S1+S2+S3 signal from eNB and relays it in the third slot, let

$$\begin{aligned} y_3 &= H_{11}^{(2)}s_3 + H_{12}^{(2)}s_2 + n_3 \\ y_4 &= H_{21}^{(2)}s_3 + H_{22}^{(2)}s_2 + n_4 \end{aligned} \tag{10}$$

where, the power factor k is merged into the channel coefficient H. The above equations may be expressed as the matrix

product of

$$\begin{bmatrix} y_0 \\ y_1 \\ y_2 \\ y_3 \\ y_4 \end{bmatrix} = \begin{bmatrix} H_{00} & 0 & 0 \\ H_{12}^{(1)} & H_{11}^{(1)} & 0 \\ H_{22}^{(1)} & H_{21}^{(1)} & 0 \\ & H_{12}^{(2)} & H_{11}^{(2)} \\ & H_{22}^{(2)} & H_{21}^{(2)} \end{bmatrix} \begin{bmatrix} s_1 \\ s_2 \\ s_3 \end{bmatrix} + \begin{bmatrix} n_0 \\ n_1 \\ n_2 \\ n_3 \\ n_4 \end{bmatrix} \qquad (11)$$

Let

$$y = \begin{bmatrix} y_0 \\ y_1 \\ y_2 \\ y_3 \\ y_4 \end{bmatrix}, H = \begin{bmatrix} H_{00} & 0 & 0 \\ H_{12}^{(1)} & H_{11}^{(1)} & 0 \\ H_{22}^{(1)} & H_{21}^{(1)} & 0 \\ & H_{12}^{(2)} & H_{11}^{(2)} \\ & H_{22}^{(2)} & H_{21}^{(2)} \end{bmatrix}, s = \begin{bmatrix} s_1 \\ s_2 \\ s_3 \end{bmatrix}, n = \begin{bmatrix} n_0 \\ n_1 \\ n_2 \\ n_3 \\ n_4 \end{bmatrix} \qquad (12)$$

The signal vector y formed by the receiver may be expressed as

$$y = Hs + n \qquad (13)$$

The optimum decoding method is ML (Maximum-Likelihood) where the receiver compares all possible combinations of slots which could have been transmitted with what is observed

$$\hat{s} = \arg\min_{\hat{s} \in S} \| y - H \cdot \hat{s} \| \qquad (14)$$

The sub-optimum decoding method is MMSE together with ZF.

But in this slot, only $s_1$ is subject to hard decision, other slots of prior information including $s_2$ and $s_3$ are used for the next slot detection.

In the following, the UE receiver and detection method is illustrated by taking UE having one receiver antenna as an example. In this case, UE can apply the joint detection technique 1): ML detection to de-spatial MUX among base station and relay, or 2) successive interference cancellation (SIC), and detection together with the prior information from eNB.

The receiver and detection method for a UE having only one receiving antenna is illustrated as follows, in which there is only one slot delay in relaying.

Firstly, UE receives S1 signal from eNB in the first slot, let

$$y_0 = H_{00}s_1 + n_0 \qquad (15)$$

Secondly, UE receives S1+S2 signal from eNB in the second slot, let

$$y_1 = H_{11}s_2 + H_{12}s_1 + n_1 \qquad (16)$$

The above equations may be expressed as the matrix product of

$$\begin{bmatrix} y_0 \\ y_1 \end{bmatrix} = \begin{bmatrix} H_{00} & 0 \\ H_{12} & H_{11} \end{bmatrix} \begin{bmatrix} s_1 \\ s_2 \end{bmatrix} + \begin{bmatrix} n_0 \\ n_1 \end{bmatrix} \qquad (17)$$

Let

$$y = \begin{bmatrix} y_0 \\ y_1 \end{bmatrix}, H = \begin{bmatrix} H_{00} & 0 \\ H_{12} & H_{11} \end{bmatrix}, s = \begin{bmatrix} s_1 \\ s_2 \end{bmatrix}, n = \begin{bmatrix} n_0 \\ n_1 \end{bmatrix} \qquad (18)$$

The signal vector y formed by the receiver may be expressed as:

$$y = Hs + n \qquad (19)$$

The optimum decoding method is ML (Maximum-Likelihood) where the receiver compares all possible combinations of slots which could have been transmitted with what is observed:

$$\hat{s} = \arg \min_{\hat{s} \in S} \| y - H \cdot \hat{s} \| \qquad (20)$$

Because the channel response matrix is a lower triangular matrix, the more simple decoding method is Successive Interference Cancellation (SIC) and MMSE (for example, another is LS or ML). The decoding method employing MMSE comprises the following steps:

Setp 1:

$$y_1 - \frac{H_{12}}{H_{00}} y_0 = H_{11} s_2 + \tilde{n}_1 \qquad (21)$$

Step2:

$$\hat{s}_2 = MMSE(s_2) \qquad (22)$$

Step3:

$$z = w_0 y_0 + w_1 (y_1 - H_{11} \hat{s}_2) = (w_0 H_{00} + w_1 H_{12}) s_1 + \tilde{n}_0 \qquad (23)$$

Step4:

$$\hat{s}_1 = MMSE(s_1) \qquad (24)$$

The MRC is applied in step3. In this slot, only the hard decision of $s_1$ is reserved.
At least, let

$$y_0^{(1)} = y_1 - H_{12}\hat{s}_1 = H_{11}s_2 + n_1 \qquad (25)$$

which is used for the next slot detection.

In the following, the receiver and detection method for a UE having only one receiving antenna is illustrated, in which there us two slot delay in relaying.

Firstly, UE receives S1 signal from eNB in the first slot, let

$$y_0 = H_{00}s_1 + n_0 \qquad (26)$$

Secondly, UE receives S1+S2 signal from eNB and relays it in the second slot. S0 in figure is a constant of 1, let

$$y_1 = H_{11}^{(1)}s_2 + H_{12}^{(1)}s_1 + n_1 \qquad (27)$$

Thirdly, UE receives S1+S2+S3 signal from eNB and relays it in the third slot, let

$$y_2 = H_{11}^{(2)}s_3 + H_{12}^{(2)}s_2 + n_2 \qquad (28)$$

where, the power factor k is merged into the channel coefficient H. The above equations may be expressed as the matrix product

$$\begin{bmatrix} y_0 \\ y_1 \\ y_2 \end{bmatrix} = \begin{bmatrix} H_{00} & 0 & 0 \\ H_{12}^{(1)} & H_{11}^{(1)} & 0 \\ & H_{12}^{(2)} & H_{11}^{(2)} \end{bmatrix} \begin{bmatrix} s_1 \\ s_2 \\ s_3 \end{bmatrix} + \begin{bmatrix} n_0 \\ n_1 \\ n_2 \end{bmatrix} \qquad (29)$$

Let

$$y = \begin{bmatrix} y_0 \\ y_1 \\ y_2 \end{bmatrix}, H = \begin{bmatrix} H_{00} & 0 & 0 \\ H_{12}^{(1)} & H_{11}^{(1)} & 0 \\ & H_{12}^{(2)} & H_{11}^{(2)} \end{bmatrix}, s = \begin{bmatrix} s_1 \\ s_2 \\ s_3 \end{bmatrix}, n = \begin{bmatrix} n_0 \\ n_1 \\ n_2 \end{bmatrix} \qquad (30)$$

The signal vector y formed by the receiver may be expressed as

$$y = Hs + n \qquad (31)$$

The optimum decoding method is ML (Maximum-Likelihood) where the receiver compares all possible combinations of slots which could have been transmitted with what is observed

$$\hat{s} = \arg \min_{\hat{s} \in S} \left\| y - H \cdot \hat{s} \right\|$$

Because the channel response matrix is a lower triangular matrix, the more simple decoding method is Successive Interference Cancellation (SIC) and MMSE (for example, another is LS or ML). The decoding method employing MMSE comprises the following steps:

Setp1:

$$y_1 - \frac{H_{12}^{(1)}}{H_{00}} y_0 = H_{11}^{(1)} s_2 + \widetilde{n}_1 \tag{32}$$

Step2:

$$\hat{s}_2 = MMSE(s_2) \tag{33}$$

Setp3:

$$y_2 - \frac{H_{12}^{(2)}}{H_{11}^{(1)}} \left( y_1 - \frac{H_{12}^{(1)}}{H_{00}} y_0 \right) = H_{11}^{(2)} s_3 + \widetilde{n}_2 \tag{34}$$

Step4:

$$\hat{s}_3 = MMSE(s_3) \tag{35}$$

Step5:

$$z = w_0 y_0 + w_1 \left( y_1 - H_{11}^{(1)} \hat{s}_2 \right) = \left( w_0 H_{00} + w_1 H_{12}^{(1)} \right) s_1 + \widetilde{n}_0 \tag{36}$$

Step6:

$$\hat{s}_1 = MMSE(s_1) \tag{37}$$

The MRC is applied in step5. In this slot, only the hard decision of $s_1$ is reserved, other hard decisions including $s_2$ and $s_3$ are used for the next slot detection.

The commercial value of the present invention will be illustrated as follows. The relay in accordance with the embodiment of the present invention does the analog network coding, i.e. the physical signals carrying information of current slot/block analog network coded with previous ones are used to transmit the service data. In amplifying and forwarding data, UE receives the signal from eNB and relays it, and detects the slot by collaborative MIMO de-spatial MUX or successive interference cancellation. Each time UE only reserves one slot hard decision, others' prior soft information are used for the next slot detection. It improves the UE receiving performance. In decoding and forwarding data, UE buffers the soft information of one block which is received from eNB, and then adopts the Chase combining or IR combining after receiving the data from relay to obtain the diversity gain. From the analysis in theory of the form of Channel Matrix united by eNB and Relay, It is found that unite detection in receiver can provide at least the similar performance as traditional 2*2 transmit diversity. Additionally, the analog network coding in relay of two symbols obtains the similar performance of 3*3 MIMO. Even due to the larger SNR received from relay, the gain would be much more.

The advantage of the present invention over the optimum prior art lies in that: joint analog network coding and wireless relay is a new application in wireless communication. Because in current HSDPA and LTE, both AMC, MAC scheduling and L1 HARQ techniques all focus on the high peak data transmission rate when UE is near the site, wireless relay joint with analog network coding is a low-cost, low-complexity solution which could improve the service transmission performance when UE is at the cell edge, and increase the cell coverage.

Although some embodiments of the present invention have been shown and illustrated, it is appreciated by those skilled in the art that the above embodiments may vary without departing from the principle and scope of the present invention defined by the accompanied claims and the equivalent thereof.

**Claims**

1. A joint analog network coding and relay method for use in a cellular network with a wireless relay, comprising steps of:

   receiving information signals from a plurality of base stations eNBs;
   sampling and analog-to-digital converting the received signals;
   analog network coding the analog signal levels carrying the information signals from the plurality of eNBs;
   forwarding symbols after being analog network coded; and
   receiving the forwarded symbols and converting the symbols into the information signals.

2. The method according to Claim 1, wherein said base station comprises a preceding relay station for forwarding data, and wherein analog network coding is preformed on the signals from said base station eNB and said preceding relay station.

3. The method according to Claim 1, wherein said relay station time alternates alternately and carries the analog network coded information signals.

4. The method according to Claim 1, wherein said analog network coding comprising a summation of physical signals.

5. The method according to Claim 4, wherein said summation of physical signals comprises a step of performing a weighting summation on signal blocks divided from time slots.

6. A reception method with a joint analog network coding and relay for use in a cellular network with a wireless relay, comprising steps of:

   performing collaborative Multiple Input and Multiple Output operation on signals received from a plurality of eNBs or Relays; and
   a User Equipment decoding the signals received through said MIMO operation by joint detection technique.

7. The method according to Claim 6, wherein said joint detection technique comprises a MIMO spatial de-multiplexing.

8. The method according to Claim 6, wherein said joint detection technique comprises a successive interference cancellation SIC.

9. The method according to Claim 6, wherein said decoding method is a Maximum-Likelihood ML method.

10. The method according to Claim 6, wherein said decoding method is a Minimum Mean-Square Error algorithm together with Zero Forcing algorithm.

11. The method according to Claim 6, wherein the Chase combining or IR combining is adopted for decoding after the UE receives the signals.

12. A base station, comprising:

    a sampling and ADC unit adapted to sample and Analog-to-Digital Convert signals to be sent;
    a coding unit adapted to analog network code analog signal levels carrying information from a plurality of eNBs; and
    a sending unit adapted to forward analog network coded symbols.

13. The base station according to Claim 12, wherein said coding unit carries out the analog signal coding by a summation of physical signals.

**14.** The base station according to Claim 12, wherein said coding unit carries out the analog signal coding by employing a weighting summation on signal blocks divided from time slots.

**15.** A user equipment, comprising:

a receiving unit adapted to receive information from a base station eNB;
a decoding unit adapted to carry out decoding by a joint detection technique; and
a sending unit adapted to forward decoded signals.

**16.** The user equipment according to Claim 15, wherein said joint detection technique comprises a MIMO spatial de-multiplexing.

**17.** The user equipment according to Claim 15, wherein said joint detection technique comprises a successive interference cancellation SIC.

**18.** The user equipment according to Claim 15, wherein said decoding unit carries out decoding by employing a Maximum-Likelihood ML method.

**19.** The user equipment according to Claim 15, wherein said decoding unit carries out decoding by a Minimum Mean-Square Error algorithm together with Zero Forcing algorithm.

**20.** The user equipment according to Claim 15, wherein the Chase combining or IR combining is adopted by said decoding unit to carry out decoding after the UE receives the signals.

**21.** A computer readable media, having a computer executable program recorded thereon, where the program, when mounted on a computer, makes the computer execute the method according to any one of claim 1 to claim 11.

**Fig. 1**

**Fig. 2**

**Fig. 3**

**Fig. 4**

## Fig. 5

## Fig. 6

S101 — receiving information signals from a plurality of base stations eNB

S102 — sampling and ADC the received signals

S103 — analog network coding the analog signals carrying the information signals from the pluraliy of eNBs

S104 — forwarding the symbols after being analog network coded

S105 — receiving the forwarded symbols and converting the symbols into the information signals

## Fig. 7

## Fig. 8

## Fig. 9a

One slot coding relay

## Fig. 9b

Tow slot coding relay

| eNB | S1 | S2 | S3 | S4 | S5 | ... |

| Relay 1 | | kS0+<br>(1-k)S1 | | kS1+<br>(1-k)S3 | | kS3+<br>(1-k)S5 | ... |

| Relay 2 | | | kS0+<br>(1-k)S2 | | kS2+<br>(1-k)S4 | | ... |

slot ⟶

## Fig. 10a

One block relay

| eNB | B1 | B2 | B3 | B4 | B5 | ... |

| Relay 1 | | B1 | | B3 | | B5 | ... |

| Relay 2 | | | B2 | | B4 | | ... |

Transmission block ⟶

## Fig. 10b

Two block coding relay （delay）

| eNB | B1 | B2 | B3 | B4 | B5 | ... |

| Relay 1 | | kB0+<br>(1-k)B1 | | kB1+<br>(1-k)B3 | | kB3+<br>(1-k)B5 | ... |

| Relay 2 | | | kB0+<br>(1-k)B2 | | kB2+<br>(1-k)B4 | | ... |

Transmission block ⟶

**Fig. 11**

```
eNB ──Y──→
         ↘
```

```
┌──────────────────────────────────────────────────────────────────┐
│  Y              Symbolizing                                     Y  │
│      ┌─────────┐    ┌───────┐  1-k  ┌──────────┐    ┌──────────┐   │
│      │Sampling │ →  │Ampli- │  →    │ Analog   │ →  │ DAC &    │   │
│      │& ADC    │    │fying  │       │ network  │    │ shaping  │   │
│      └─────────┘    └───────┘       │ coding   │    └──────────┘   │
│                         │           └──────────┘                   │
│                         │              ↑ k                         │
│                         ↓     ┌────────┐                           │
│                         →     │ Delay  │                           │
│                               └────────┘                           │
│  Relay                                                             │
└──────────────────────────────────────────────────────────────────┘
```

**Fig. 12**

```
eNB ──Y──→
         ↘
```

```
┌────────────────────────────────────────────────────────────────────────────────┐
│  Y                                                        TB                      │
│    ┌─────────┐          ┌──────────┐                                          Y   │
│    │Sampling │  ──────→ │Amplifying│ ──────→      No    1-k  ┌─────────┐ ┌────────┐│
│    │& ADC    │          └──────────┘           ╱          → │Analog   │ │DAC &   ││
│    └─────────┘                          TB     ╱             │network  │ │sampling││
│         │                                     ╱              │coding · │ └────────┘│
│         ↓                                    ╱               └─────────┘           │
│  ┌────────┐ ┌───────┐ ┌──────┐ ┌──────────┐ ╱ Yes      k                          │
│  │demodul │→│Decoding│→│Coding│→│Modulating│→        ┌─────────┐                  │
│  │ating   │ └───────┘ └──────┘ └──────────┘          │Delaying │                  │
│  └────────┘     │                                    └─────────┘                  │
│                 │              ┌──────────┐                                        │
│                 └──────────→   │CRC       │ - - - - -                              │
│                                │Checking  │                                        │
│                                └──────────┘                                        │
│  Relay                                                                             │
└────────────────────────────────────────────────────────────────────────────────┘
```

**Fig. 13**

Half-Duplex

Relay 1

Time Alternate

eNB

Relay 2

## One slot relay

| eNB | S1 | S2 | S3 | S4 | S5 | ... |
|-----|----|----|----|----|----|-----|

| Relay 1 | | S1 | | S3 | | S5 | ... |
|---------|--|----|--|----|--|----|-----|

| Relay 2 | | | S2 | | S4 | | ... |
|---------|--|--|----|--|----|--|-----|

Slot →

**Fig. 14**

## Two slot coding relay

| eNB | S1 | S2 | S3 | S4 | S5 | ... |
|-----|----|----|----|----|----|-----|

| Relay 1 | | kS0+<br>(1-k)S1 | | kS1+<br>(1-k)S3 | | kS3+<br>(1-k)S5 | ... |
|---------|--|-----------------|--|-----------------|--|-----------------|-----|

| Relay 2 | | kS0+<br>(1-k)S2 | | kS2+<br>(1-k)S4 | | | ... |
|---------|--|-----------------|--|-----------------|--|--|-----|

slot →

**Fig. 15**

# INTERNATIONAL SEARCH REPORT

International application No.

PCT/CN2009/000128

### A. CLASSIFICATION OF SUBJECT MATTER

See extra sheet

According to International Patent Classification (IPC) or to both national classification and IPC

### B. FIELDS SEARCHED

Minimum documentation searched (classification system followed by classification symbols)

IPC: H04L; H04Q; H04M; H04W; H04B

Documentation searched other than minimum documentation to the extent that such documents are included in the fields searched

Electronic data base consulted during the international search (name of data base and, where practicable, search terms used) CNPAT; CNKI; WPI; EPODOC; PAJ analog network coding relay sampling analog to digital conversion ADC MIMO joint detect+

### C. DOCUMENTS CONSIDERED TO BE RELEVANT

| Category* | Citation of document, with indication, where appropriate, of the relevant passages | Relevant to claim |
|---|---|---|
| Y | Olga Munoz et al. Cellular capacity gains of cooperative MIMO transmission in the downlink. Int. Zurich Seminar on Communications (IZS). Feb. 18-20, 2004, pages 22-26 | 1-21 |
| Y | Sachin Katti et al. Embracing Wireless Interference: Analog Network Coding. SIGCOMM'07, August 27–31, 2007, Kyoto, Japan. Pages 1-12 | 1-21 |
| A | US2007/0184826A1 (SAMSUNG ELECTRONICS CO., LTD.) 09 Aug. 2007 (09.08.2007) See the whole document | 1-21 |
| A | KR10-0787969B1 (IND ACADEMIC COOP) 24 Dec. 2007 （24.12.2007） See the whole document | 1-21 |
| A | CN1881965A (NTT DOCOMO, INC.) 20 Dec. 2006 （20.12.2006） See the whole document | 1-21 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 28 Apr. 2009 （28.04.2009） | **14 May 2009 (14.05.2009)** |

| Name and mailing address of the ISA/CN | Authorized officer |
|---|---|
| The State Intellectual Property Office, the P.R.China 6 Xitucheng Rd., Jimen Bridge, Haidian District, Beijing, China 100088 Facsimile No. 86-10-62019451 | CAI,Jian Telephone No. (86-10)62413389 |

Form PCT/ISA/210 (second sheet) (April 2007)

# INTERNATIONAL SEARCH REPORT

International application No.

PCT/CN2009/000128

**Box No. II      Observations where certain claims were found unsearchable (Continuation of item 2 of first sheet)**

This international search report has not been established in respect of certain claims under Article 17(2)(a) for the following reasons:

1. ☐   Claims Nos.:
because they relate to subject matter not required to be searched by this Authority, namely:

2. ☐   Claims Nos.:
because they relate to parts of the international application that do not comply with the prescribed requirements to such an extent that no meaningful international search can be carried out, specifically:

3. ☐   Claims Nos.:
because they are dependent claims and are not drafted in accordance with the second and third sentences of Rule 6.4(a).

**Box No. III   Observations where unity of invention is lacking (Continuation of item 3 of first sheet)**

This International Searching Authority found multiple inventions in this international application, as follows:

I: Claim 1 deals with a relaying method for joint analog network coding.

II: Claim 6 deals with a relay receiving method for joint analog network coding.

III: Claim 12 deals with a base station.

IV: Claim 15 deals with an user equipment.

   There are no specific technical features between the above claims, so the application does not meet the requirement of unity of invention as defined in Rules 13.1 PCT.

1. ☐   As all required additional search fees were timely paid by the applicant, this international search report covers all searchable claims.

2. ☒   As all searchable claims could be searched without effort justifying an additional fees, this Authority did not invite payment of any additional fee.

3. ☐   As only some of the required additional search fees were timely paid by the applicant, this international search report covers only those claims for which fees were paid, specifically claims Nos.:

4. ☐   No required additional search fees were timely paid by the applicant. Consequently, this international search report is restricted to the invention first mentioned in the claims; it is covered by claims Nos.:

**Remark on protest**          ☐   The additional search fees were accompanied by the applicant's protest and, where applicable, the payment of a protest fee.

☐   The additional search fees were accompanied by the applicant's protest but the applicable protest fee was not paid within the time limit specified in the invitation.

☐   No protest accompanied the payment of additional search fees.

Form PCT/ISA/210 (continuation of first sheet (2)) (April 2007)

## INTERNATIONAL SEARCH REPORT
Information on patent family members

| International application No. |
|---|
| *PCT/CN2009/000128* |

| Patent Documents referred in the Report | Publication Date | Patent Family | Publication Date |
|---|---|---|---|
| US2007/0184826A1 | 09.08.2007 | None | |
| KR10-0787969B1 | 24.12.2007 | None | |
| CN1881965A | 20.12.2006 | EP1729435A1 | 06.12.2006 |
| | | JP2006352855A | 28.12.2006 |
| | | US2006291440A1 | 28.12.2006 |
| | | DE602005005031E | 10.04.2008 |

Form PCT/ISA/210 (patent family annex) (April 2007)

# INTERNATIONAL SEARCH REPORT

International application No.

PCT/CN2009/000128

Continuation of CLASSIFICATION OF SUBJECT MATTER

H04B7/04 (2006.01) i

H04B7/14 (2006.01) i

H03M13/37 (2006.01) i

H04W88/02 (2009.01) i

Form PCT/ISA/210 (extra sheet) (April 2007)